# EUROPEAN PATENT APPLICATION

(11) **EP 1 850 334 A1**
(43) Date of publication of application: **31.10.2007**
(21) Application number: 06254396.2
(22) Date of filing: 22.08.2006
(51) Int. Cl.: G11B 5/73, G11B 5/84, C23C 14/34, G11B 5/21

(54) **Soft magnetic underlayer in magnetic media and soft magnetic alloy based sputter target**

(30) Priority: 27.04.2006 US 411813
(71) Applicant: Heraeus, Inc., Chandler AZ 85226 (US)
(72) Inventor: Racine, Michael Gene, Phoenex, AZ 85044 (US); Kennedy, Steven Roger, Chandler, Az 85226 (US); Das, Anirban, Tempe az85283 (US)
(74) Representative: Hill, Justin John

(57) **Abstract**

A magnetic recording medium that includes a substrate, an underlayer deposited above the substrate, the underlayer comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al), and a magnetic data recording layer deposited above the underlayer. A sputter target comprised of the magnetically soft alloy is also provided, and the magnetically soft alloy is also used in soft magnetic layers on magnetic recording heads.

## Description

### FIELD OF THE INVENTION

The present invention generally relates to sputter targets and magnetic recording media. In particular, the invention relates to corrosion-resistant soft magnetic alloy based sputter targets, and the use of such targets to deposit a soft magnetic film for application in perpendicular magnetic recording media, and on magnetic recording heads.

### BACKGROUND OF THE INVENTION

To satisfy the continual demand for even greater data storage capacities, higher density magnetic recording media are required. Of the approaches to achieve this high data density, perpendicular magnetic recording (PMR) by far appears to be the most promising. In contrast to longitudinal magnetic recording, the magnetic data recording layer of the recoding media has its magnetic lines directed perpendicular to the axis of the recording media in perpendicular magnetic recording. Also, in perpendicular magnetic recording, a higher writing field can be obtained by using a soft magnetic under-layer (SUL) beneath the magnetic data recording layer.

For example, a single-pole recording head and a corresponding magnetic recording media having a soft underlayer enables write fields in excess of double of that which is available for conventional longitudinal recording. Accordingly, acting as a magnetic mirror, a SUL effectively doubles the recording layer thickness, facilitating stronger read-out signals. These soft under layers are magnetically soft (with High magnetic induction (Bs), high permeability (µₑ), low coercivity (Hc)) alloys, such as alloys of Co, Ni and Fe. Similar magnetically soft layers based on these alloys are also used as components in writer pole and reader sensor elements contained in magnetic recording head designs.

Although higher writing fields and performance can be achieved in PMR applications using magnetically soft alloys as described above, such alloys can have a high propensity for corrosion, thereby potentially causing severe reliability issues in both the magnetic recording media and in the recording head during hard disk drive operations.

### SUMMARY OF THE INVENTION

The present invention solves the foregoing problems by providing corrosion-resistant soft magnetic alloy based sputter targets for use to deposit a corrosion-resistant soft magnetic underlayer in magnetic recording media, and soft magnetic layers on magnetic recording heads, for reliable, high performance perpendicular magnetic recording.

In accordance with one embodiment of the present invention, a magnetic recording medium having a corrosion-resistant soft magnetic underlayer is provided. Specifically, a magnetic recording medium is provided that includes a substrate, an underlayer deposited above the substrate, the underlayer being comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al), and a magnetic data recording layer deposited above the underlayer.

In another embodiment, the present invention is a magnetic recording head that includes a writer pole and a reader sensor, wherein the writer pole and the reader sensor include an soft magnetic film disposed above a substrate, the soft magnetic film comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al).

According to a further embodiment, the present invention is directed to a method of manufacturing a magnetic recording medium, including a first sputtering step of sputtering an underlayer above a substrate from a first sputter target that is comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al), and a second sputtering step of sputtering a magnetic data recording layer above the underlayer from a second sputter target.

According to yet another embodiment, the present invention is directed to a sputter target including a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al).

In a further embodiment, the invention is directed to a method of manufacturing a magnetic recording head having a writer pole and a reader sensor, the method including a sputtering step of sputtering a magnetically soft film above a substrate deposited on at least one of the writer pole and the reader sensor, the magnetically soft film being sputtered from a sputter target that is comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al).

In the above embodiments, the at least one soft ferromagnetic element is preferably selected from the group consisting of cobalt (Co), iron (Fe) and nickel (Ni), and the at least one corrosion inhibitor element is selected from a subset of the above-listed group of inhibitor elements depending on the selected ferromagnetic element. In addition, the amount of the inhibitor element included in the magnetically soft alloy is limited up to a predetermined limit of atomic ratio, where the predetermined atomic ratio limit is determined according to which soft ferromagnetic element(s) is selected and on which inhibitor element is selected.

In this manner, a magnetically soft alloy is provided that has a high saturation magnetic induction (Bs) greater than 0.5 Tesla, a high permeability (µₑ) of greater than 10.0 at 1KHz, and a low coercivity (Hc) of less than 8000 oestead.

Additional features and advantages of the invention will be set forth in the description below, and in part will be apparent from the description, or may be learned by practice of the invention. The objectives and other advantages of the invention will be realized and attained by the structure particularly pointed out in the written description and claims hereof as well as the appended drawings.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention.

FIGURE 1 depicts a thin film stack of a recording medium having a soft magnetic underlayer according to one embodiment of the present invention.

FIGURES 2A-2E depict recording head components having a soft magnetic film layer according to one embodiment of the present invention.

FIGURE 3 depicts the sputtering of a soft magnetic film layer onto a recording medium (or recording head component) according to one embodiment of the present invention.

FIGURE 4 is a flowchart for explaining the method of making a recording medium, or recording head components, having a soft magnetic film layer according to one embodiment of the present invention.

### DETAILED DESCRIPTION OF THE INVENTION

In the following detailed description, numerous specific details are set forth to provide a full understanding of the present invention. It will be apparent, however, to one ordinarily skilled in the art that the present invention may be practiced without some of these specific details. In other instances, well-known structures and techniques have not been shown in detail to avoid unnecessarily obscuring the present invention.

The invention is generally directed to providing corrosion-resistant soft magnetic alloy based sputter targets for use to deposit a corrosion-resistant soft magnetic film layer as an underlayer in a perpendicular magnetic recording medium stack, and as a magnetically soft film layer on magnetic recording heads, for reliable, high performance magnetic recording. In this manner, magnetic recording media, and magnetic recording head components, are produced having a corrosion-resistant soft magnetic underlayer, resulting in higher write fields and in reliable, corrosion-resistant performance.

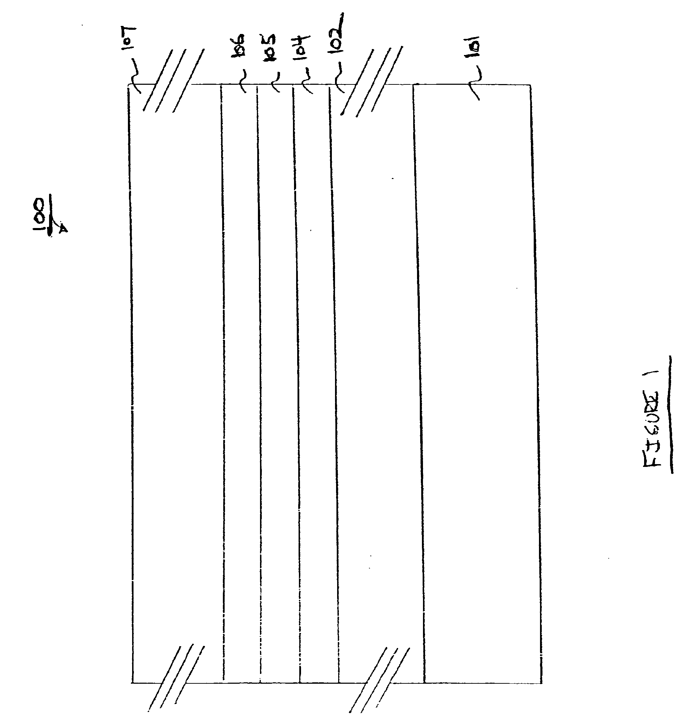

Figure 1 depicts a magnetic recording medium 100 of the present invention which has a thin film stack including a corrosion-resistant soft magnetic underlayer 104 which was formed during a sputter process using a sputter target according to the present invention. As seen in Figure 1, magnetic recording medium 100 includes substrate 101 1 and corrosion-resistant soft magnetic underlayer 104. Layer 102, which is optional, can include one or more underlayers, anti-ferromagnetic layer, or other type of layer which is deposited between substrate 101 and underlayer 104. In alternate aspects of the present invention, layer 102 is omitted. Similarly, optional layer(s) 105 is optionally provided in the thin film stack in order to optionally provide additional layers, such as a seedlayer or other underlayers, between underlayer 104 and recording layer 106. In alternate aspects of the present invention, optional layer(s) 105 is omitted.

As mentioned above, underlayer 104 is deposited above the substrate 101, or above intervening optional low-level layers 102. Underlayer 104 is comprised of a corrosion-resistant soft magnetic alloy, as discussed in more detail herein. As seen in Figure 1, magnetic recording medium 100 includes magnetic data recording layer 106 deposited above underlayer 104. Magnetic recording medium 100 further includes optional protective layer 107, which can be optionally provided and which can include one or more layers such as a carbon (C) overcoat or a lubricant layer, although in alternate aspects protective layer 107 is omitted. Magnetic data recording layer 106 has magnetic lines that are perpendicular to the plane of substrate 101. In contrast, underlayer 104 has magnetic lines that are in the plane of substrate 101, thereby creating a magnetic loop with magnetic data recording layer 106.

In this manner, underlayer 104 of the present invention enables magnetic recording medium 100 to achieve reliable, high performance perpendicular magnetic recording (PMR) during operation of magnetic recording medium 100. Underlayer 104 acts as a magnetic mirror and effectively doubles the thickness of magnetic data recording layer 106, resulting in stronger readout signals from magnetic recording medium 100. Specifically, underlayer 104 is comprised of a corrosion-resistant soft magnetic alloy, which contains at least one or more soft ferromagnetic element, and at least one corrosion inhibitor element. In this regard, the soft ferromagnetic element(s) in the soft magnetic alloy is preferably one of, or any combination of, cobalt (Co), iron (Fe) and nickel (Ni), although other soft ferromagnetic elements can also be included in the soft magnetic alloy. In the present invention, the soft magnetic alloy also contains one or more corrosion inhibitor elements which are selected based on the soft ferromagnetic element(s) selected to be in the soft magnetic alloy. This is because some corrosion inhibitor elements are effective to resist corrosion in an alloy having certain selected soft ferromagnetic elements but not others.

Table 1, below, provides a list of corrosion inhibitor elements that can be used in the present invention to form the corrosion-resistant soft magnetic alloy used in conjunction with one or more of soft ferromagnetic elements cobalt (Co), iron (Fe) and nickel (Ni). As mentioned above, the set of corrosion inhibitor elements that can be effectively used with each of the soft ferromagnetic elements are different, because some corrosion inhibitor elements work effectively with some soft ferromagnetic elements but not with others.

**Table 1: Corrosion inhibitors for each soft ferromagnetic element**

| **COBALT (Co) ALLOY CORROSION INHIBITORS** | **IRON (Fe) ALLOY CORROSION INHIBITORS** | **NICKEL (Ni) ALLOY CORROSION INHIBITORS** |
|---|---|---|
| Chromium (Cr) (up to 25% atomic ratio) | Chromium (Cr) (up to 30% atomic ratio) | Chromium (Cr) (up to 30% atomic ratio) |
| Tungsten (W) (up to 15% atomic ratio) | Tungsten (W) (up to 5% atomic ratio) | Tungsten (W) (up to 4% atomic ratio) |
| Molybdenum (Mo) (up to 10% atomic ratio) | Molybdenum (Mo) (up to 5% atomic ratio) | Molybdenum (Mo) (up to 28% atomic ratio) |
| Carbon (C) (up to 2% atomic ratio) | Carbon (C) (up to 0.3% atomic ratio) | Carbon (C) (up to 2% atomic ratio) |
| Copper (Cu) (up to 2% atomic ratio) | Nickel (Ni) (up to 30% atomic ratio) | Copper (Cu) (up to 3% atomic ratio) |
| Nickel (Ni) (up to 20% atomic ratio) | Manganese (Mn) (up to 15% atomic ratio) | Aluminum (A1) (up to 2% atomic ratio) |
| - | Nitrogen (N) (up to 0.4% atomic ratio) | Tantalum (Ta) (up to 10% atomic ratio) |
| - | Titanium (Ti) (up to 2% atomic ratio) | Titanium (Ti) (up to 2% atomic ratio) |
| - | Niobium (Nb) (up to 2% atomic ratio) | Niobium (Nb) (up to 10% atomic ratio) |
| - | Silicon (Si) (up to 1% atomic ratio) | Silicon (Si) (up to 11% atomic ratio) |

As seen in Table 1, a list of corrosion inhibitor elements is provided for each one of the soft ferromagnetic elements cobalt (Co), iron (Fe) and nickel (Ni). In the present invention, the corrosion-resistant soft magnetic alloy includes one or more of soft ferromagnetic elements cobalt (Co), iron (Fe) and nickel (Ni) and one or more of the corrosion inhibitor elements from the list in Table 1 corresponding to each ferromagnetic element included in the alloy.

For example, if the alloy contains cobalt (Co), then one or more of corrosion inhibitor elements chromium (Cr), tungsten (W), molybdenum (Mo), carbon (C), copper (Cu), and nickel (Ni) is selected to include in the alloy to provide corrosion resistant properties for the cobalt (Co) in the alloy. As seen in Table 1, each one of the listed corrosion inhibitor elements is associated with an upper limit of percentage of atomic ratio. This represents the upper limit of atomic ratio with respect to the corresponding ferromagnetic element for the amount of the particular corrosion inhibitor element included in the alloy. For example, an alloy containing cobalt (Co) along with the selected corrosion inhibitor element of tungsten (W) could have up to 15% of tungsten (W) by atomic ratio with respect to the amount of cobalt (Co) in the alloy. In other words, if the alloy contains one million atoms of cobalt (Co), then up to 150,000 atoms of tungsten (W) could be in the alloy. The upper limits are provided for the corrosion inhibitor elements in association with each of the soft ferromagnetic elements because the effectiveness of a corrosion inhibitor element is not increased when the corrosion inhibitor element is added into the alloy beyond that upper limit, and because the addition of the corrosion inhibitor element beyond the upper limit may affect the soft magnetic properties of the alloy.

As seen in Table 1, the corrosion inhibitor elements listed in Table 1 are different for each of the corresponding soft ferromagnetic elements cobalt (Co), iron (Fe) and nickel (Ni). In this manner, the present invention provides combinations of soft magnetic alloys that can be used in underlayer 104 of magnetic recording medium 100, and for making sputter targets which are used to make underlayer 104. Turning to the other columns of Table 1, it can be seen that, if the alloy contains iron (Fe), then one or more of corrosion inhibitor elements chromium (Cr), tungsten (W), molybdenum (Mo), carbon (C), nickel (Ni), manganese (Mn), nitrogen (N), titanium (Ti), niobium (Nb), and silicon (Si) is selected to include in the alloy to provide corrosion resistant properties for the cobalt (Fe) in the alloy.

Similarly, if the alloy contains nickel (Ni), then one or more of corrosion inhibitor elements chromium (Cr), tungsten (W), molybdenum (Mo), carbon (C), copper (Cu). aluminum (Al), tantalum (Ta), titanium (Ti), niobium (Nb), and silicon (Si) is selected to include in the alloy to provide corrosion resistant properties for the cobalt (Ni) in the alloy. As mentioned above, the corrosion-resistant soft magnetic alloy of the present invention can also be comprised of two or more of soft ferromagnetic elements cobalt (Co), iron (Fe) and nickel (Ni). For example the corrosion-resistant soft magnetic alloy can be a Co-Fe alloy, a Co-Ni alloy or a Co-Fe-Ni alloy, or any other possible combination of soft ferromagnetic elements cobalt (Co), iron (Fe) and nickel (Ni). In such a case, one or more of the corrosion inhibitor elements can be selected from the respective column of Table 1 corresponding to each of the soft ferromagnetic elements included in the alloy. The amount of the selected corrosion inhibitor elements could can be included up to the atomic ratio limit provided in the column with respect to the amount of the ferromagnetic element for that column included in the alloy.

It can be appreciated upon review of Table 1 that a same corrosion inhibitor element, such as tungsten (W), can be used for all three ferromagnetic elements cobalt (Co), iron (Fe) and nickel (Ni) in the case of a Co-Fe-Ni alloy. In such an example, the amount of tungsten (W) included in the alloy could include a separate amount of tungsten (W) up to the atomic ratio limit provided in Table 1 for each of cobalt (Co), iron (Fe) and nickel (Ni). In this manner, the desired soft magnetic properties of the soft magnetic alloy are maintained, and the appropriate amount of corrosion resistance is included in the alloy. Specifically, the corrosion resistant soft magnetic alloy provided for underlayer 104 of the present invention has a high saturation magnetic induction (Bs) greater than 0.5 Tesla, and has soft magnetic behavior with a high permeability (µₑ) of greater than 10.0 at 1KHz, and with a low coercivity (Hc) of less than 8000 oestead.

The corrosion resistant soft magnetic alloy of underlayer 104 can also include other elements in addition to one or more of the soft ferromagnetic elements cobalt (Co), iron (Fe) and nickel (Ni), and one or more of the corrosion inhibitor elements listed in Table 1. The underlayer 104 of the present invention is either in a nanocrystalline form or an amorphous form. Accordingly, it may be desirable to include one or more nucleating agent to the corrosion resistant soft magnetic alloy in order to obtain nanocrystalline form in the soft magnetic alloy film of underlayer 104. In this regard, such nucleating agents can include one or more of the noble metals, such as copper (Cu), silver (Ag), and gold (Au), for example.

In the alternative, it may be desirable to include one or more glass-forming additives to the corrosion resistant soft magnetic alloy in order to obtain an amorphous form in the soft magnetic alloy film of underlayer 104. In this manner, it is possible for underlayer 104 to be comprised of a single magnetic domain. Such glass-forming additives can include one or more of the early transition elements, such as zirconium (Zr), hafnium (Hf), vanadium (V), tantalum (Ta), and niobium (Nb), for example, and the metalloids, such as boron (B), silicon (Si), germanium (Ge), arsenic (As), antimony (Sb), and tellurium (Te), for example. Known methods can be used to include one or more of such nucleating agents or glass-forming additives into the alloy.

The corrosion resistant soft magnetic alloy discussed above with respect to underlayer 104 of magnetic recording medium 100 can also be used to form a soft magnetic film layer in the components of a recording head for increased performance in a perpendicular magnetic recording (PMR) head.

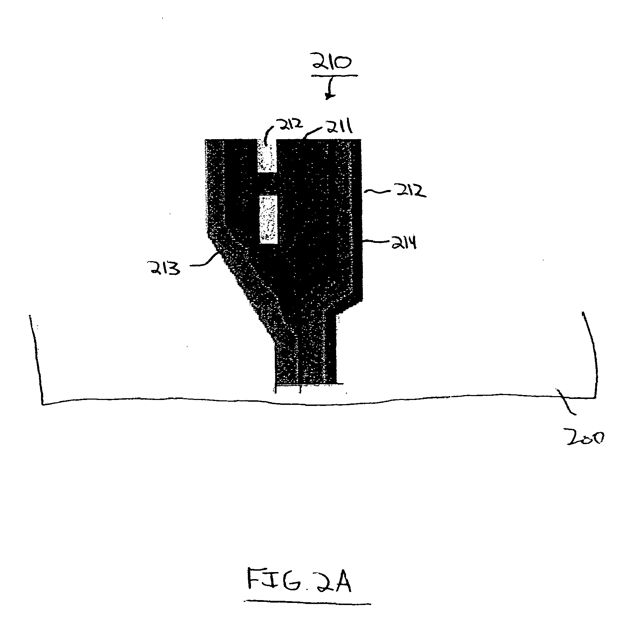

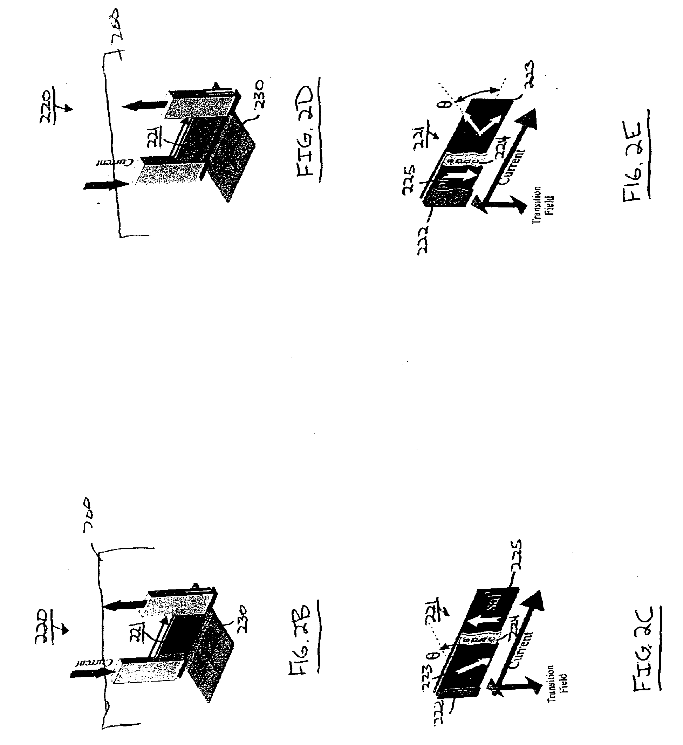

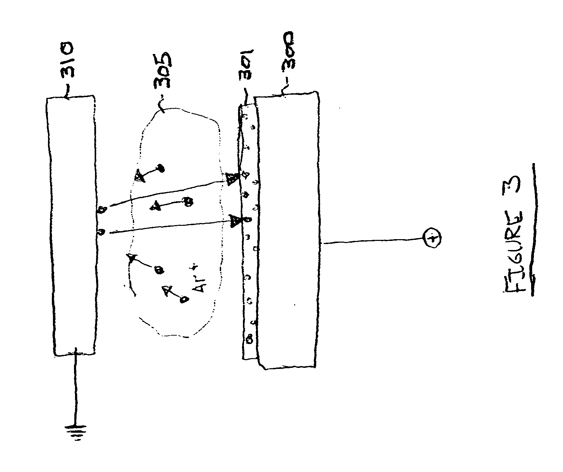

In this regard, Figure 2A depicts a perpendicular magnetic recording (PMR) head 200 which includes writer pole 210 according to an embodiment of the present invention. As seen in Figure 2, writer pole 210 includes several layers 211 to 214. Specifically, writer pole 210 has substrate 211 which is preferably a baked photo-resist layer. A soft magnetic film layer 213 is deposited above substrate 211, according to the invention. Writer pole 210 also includes copper elements and layer 212 and alloy layer 214, which is preferably an aluminum oxide layer. It should be appreciated that the layers shown for writer pole are exemplary, and that layers 211, 212 and 214 can be comprised of other elements and/or alloys.

As mentioned above, soft magnetic film layer 213 is deposited above the substrate 211, and is comprised of a corrosion-resistant soft magnetic alloy, as described above with respect to the corrosion-resistant soft magnetic alloy of underlayer 104 of magnetic recording medium 100 shown in Figure 1. Accordingly, the reader is referred to the above discussion of Figure 1, and Table 1, for a description of the corrosion-resistant soft magnetic alloy that is also used for soft magnetic film layer 213 of writer pole 210.

Figures 2B illustrates reader sensor 220 as a component of recording head 200, although reader sensor 220 can be separately provided in other alternative embodiments. As shown in Figure 2B, reader sensor 220 has a sensor unit 221 which has current applied to it in operation in order to read the magnetic segments of medium 230. Figure 2C shows the layer stack of sensor unit 221 shown in Figure 2B. In this regard, sensor unit 221 is seen to include antiferromagnetic layer 222, free ferromagnet layer 223, spacer layer 224, and soft adjacent layer 225. In this regard, according to this embodiment of the invention, free ferromagnet layer 223 and soft adjacent layer 225 are a soft magnetic film layer which is comprised of a corrosion-resistant soft magnetic alloy, as described above with respect to the corrosion-resistant soft magnetic alloy of underlayer 104 of magnetic recording medium 100 shown in Figure 1. In this manner, sensor unit 221 is an efficient and corrosion resistant in operation.

Figures 2D illustrates another embodiment of reader sensor 220 as a component of recording head 200, although reader sensor 220 can be separately provided in other alternative embodiments. As shown in Figure 2D, reader sensor 220 has a sensor unit 221 which has current applied to it in operation in order to read the magnetic segments of medium 230. Figure 2E shows the layer stack of sensor unit 221 shown in Figure 2D. In this regard, sensor unit 221 is seen to include antiferromagnetic layer 222, free ferromagnet layer 223, spacer layer 224, and pinned ferromagnetic layer 225. In this regard, according to this embodiment of the invention, free ferromagnet layer 223 and pinned ferromagnetic layer 225 are a soft magnetic film layer which is comprised of a corrosion-resistant soft magnetic alloy, as described above with respect to the corrosion-resistant soft magnetic alloy of underlayer 104 of magnetic recording medium 100 shown in Figure 1. In this manner, sensor unit 221 is an efficient and corrosion resistant in operation. In the embodiments of reader sensor 220 described above in Figures 2B to 2E, sensor unit 221 can also optionally include a protective layer (not shown), which can be one or more layers such as a carbon (C) overcoat or a lubricant layer.

Figure 3 is a graphic diagram that depicts the sputtering of a corrosion resistant soft magnetic alloy film onto a recording medium (or onto a recording head component) according to the present invention. Turning to Figure 3, substrate 300 is shown which can be the substrate of a magnetic medium, such as magnetic recording medium 100, or the substrate of a recording head component, such as writer pole 210 or reader sensor 220 of recording head 200. In this regard, a corrosion resistant soft magnetic alloy film is being applied as an underlayer 301 onto substrate 300 of a recording medium by a sputtering process. It should be appreciated that known types of sputtering processes and equipment can be used in order to apply the corrosion resistant soft magnetic alloy film of the invention to create underlayer 301. The simplified depiction of a sputtering process shown in Figure 3 is for explanatory purposes, and other sputtering processes and equipment can be used to practice the invention without detracting from or limiting the scope of the invention.

As seen in Figure 3, sputter target 310 is provided, which is comprised of a corrosion-resistant soft magnetic alloy, as described above with respect to the corrosion-resistant soft magnetic alloy of underlayer 104 of magnetic recording medium 100 shown in Figure 1. Accordingly, the reader is referred to the above discussion of Figure 1, and Table 1, for a description of the corrosion-resistant soft magnetic alloy that makes up sputter target 310. Sputter target 310 can be round, square, rectangular, or any number of other shapes, such as solid or hollow cylindrical, or nearly any other shape. Sputter target 310 is formed of the corrosion-resistant soft magnetic alloy of the present invention according to any of several known processes, such as induction melting, ingot gas melting, and powder metallurgy, for example.

In the example shown in Figure 3, sputter target 310, comprised of the corrosion-resistant soft magnetic alloy described above with respect to Figure 1 and Table 1, is electrically grounded. In contrast, a positive electrical charge is applied to substrate 300. A cloud of ionized Argon gas 305 is shown in Figure 3 disposed between sputter target 310 and substrate 300. Ionized Argon gas 305, having a positive charge, has a velocity vector directed toward the surface of sputter target 310, partially due to the electrical ground applied to sputter target 310. The ionized gas bombards the surface of sputter target 310 and dislodges, or sputters, particles of the corrosion-resistant soft magnetic alloy from sputter target 310. These particles of the sputtered corrosion-resistant soft magnetic alloy are ejected away from sputter target 310 and onto the surface of substrate 300, partially due to the positive charge applied to substrate 300. This process is continued until a thin film of the corrosion-resistant soft magnetic alloy having the desired thickness is applied above the surface of substrate 300, thereby forming underlayer 301 above substrate 300. Of course, other intervening layers can be placed between substrate 300 and underlayer 301, as described above with respect to Figure 1. Other known types of sputter targets can be used to sputter other types of layers onto substrate 300, such as a magnetic recording layer in the case of a magnetic data recording medium.

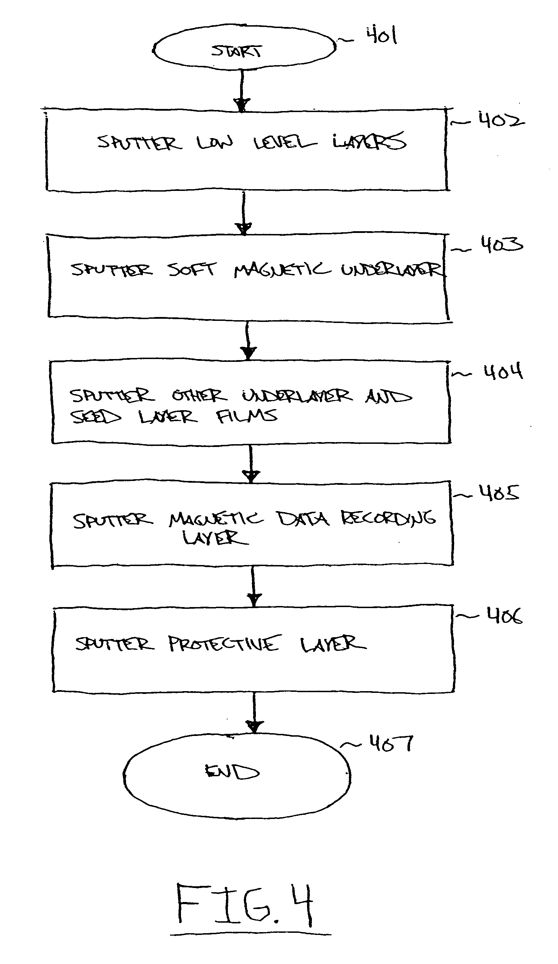

Figure 4 is a flowchart for explaining the steps of one exemplary embodiment of the invention in which a magnetic recording medium is manufactured having an underlayer of corrosion-resistant soft magnetic alloy, and can also be used to generally depict the creation of a corrosion-resistant soft magnetic alloy film in a recording head component. The process starts in step 401, and, in step 402, certain low-level layers, such as an anti-ferromagnetic layer, other types of underlayers, are deposited above the substrate using sputtering from one or more sputter targets. In alternate aspects of the present invention, step 402 is omitted.

Next, a corrosion resistant soft magnetic alloy underlayer is sputtered above the substrate, or above low level layers if any were applied, from a corrosion resistant soft magnetic alloy sputter target (step 403). The corrosion resistant soft magnetic alloy sputter target is comprised of a corrosion-resistant soft magnetic alloy as described above with respect to Figure 1 and Table 1. The sputtering process can be that described above with respect to Figure 3, or can be some other known sputtering process.

After the corrosion resistant soft magnetic alloy underlayer is applied in step 403, other underlayers or a seed layer may optionally be sputtered above the corrosion resistant soft magnetic alloy underlayer (step 404). At least one magnetic data recording layer is then sputtered above the corrosion resistant soft magnetic alloy underlayer (or above intervening underlayers or seed layer) from a different sputter target. (step 405). An additional protective layer or layers, such as a carbon (C) overcoat and/or a lubricant layer, are sputtered above the magnetic data recording layer in step 406, and the process ends (step 407). In alternate aspects, step 406 is omitted and no protective layer is sputtered onto the magnetic data recording layer. Of course, other steps can be added or omitted from the foregoing exemplary process to manufacture a magnetic recording medium without departing from the scope of the invention.

While the present invention has been particularly described with reference to the various figures and embodiments, it should be understood that these are for illustration purposes only and should not be taken as limiting the scope of the invention in any way. For example, although sputter targets implementing the present invention may be round, square, rectangular, or any number of other shapes, such as rectilinear, solid or hollow cylindrical, or nearly any other shape. It is to be appreciated that changes and modifications may be made to the invention by one having ordinary skill in the art without departing from the spirit and scope of the invention.

## Claims

1. A magnetic recording medium, comprising:
a substrate;
an underlayer deposited above the substrate, the underlayer comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (A1); and
a magnetic data recording layer deposited above the underlayer.

2. The magnetic recording medium of claim 1, wherein the at least one soft ferromagnetic element is selected from the group consisting of cobalt (Co), iron (Fe) and nickel (Ni).

3. The magnetic recording medium of claim 1, wherein the at least one soft ferromagnetic element is a combination of at least two elements selected from the group consisting of cobalt (Co), iron (Fe) and nickel (Ni).

4. The magnetic recording medium of claim 1, wherein the at least one soft ferromagnetic element is cobalt (Co), and the at least one corrosion inhibitor element is selected from the group consisting of chromium (Cr), tungsten (W), molybdenum (Mo), carbon (C), copper (Cu), and nickel (Ni).

5. The magnetic recording medium of claim 4, wherein the selected corrosion inhibitor element is included in the magnetically soft alloy according to the following atomic ratio limits: up to 25% atomic ratio of chromium (Cr), up to 15% atomic ratio of tungsten (W), up to 10% atomic ratio of molybdenum (Mo), up to 2% atomic ratio of carbon (C), up to 2% atomic ratio of copper (Cu), and up to 20% atomic ratio of nickel (Ni).

6. The magnetic recording medium of claim 1, wherein the at least one soft ferromagnetic element is iron (Fe), and the at least one corrosion inhibitor element is selected from the group consisting of chromium (Cr), tungsten (W), molybdenum (Mo), carbon (C), nickel (Ni), manganese (Mn), nitrogen (N), titanium (Ti), niobium (Nb), and silicon (Si).

7. The magnetic recording medium of claim 6, wherein the selected corrosion inhibitor element is included in the magnetically soft alloy according to the following atomic ratio limits: up to 30% atomic ratio of chromium (Cr), up to 5% atomic ratio of tungsten (W), up to 5% atomic ratio of molybdenum (Mo), up to 0.3% atomic ratio of carbon (C), up to 30% atomic ratio of nickel (Ni), up to 15% atomic ratio of manganese (Mn), up to 0.4% atomic ratio of nitrogen (N), up to 2% atomic ratio of titanium (Ti), up to 2% atomic ratio of niobium (Nb), and up to 1% atomic ratio of silicon (Si).

8. The magnetic recording medium of claim 1, wherein the at least one soft ferromagnetic element is nickel (Ni), and the at least one corrosion inhibitor element is selected from the group consisting of chromium (Cr), tungsten (W), molybdenum (Mo), carbon (C), copper (Cu), titanium (Ti), niobium (Nb), silicon (Si), tantalum (Ta), and aluminum (A1).

9. The magnetic recording medium of claim 8, wherein the selected corrosion inhibitor element is included in the magnetically soft alloy according to the following atomic ratio limits: up to 30% atomic ratio of chromium (Cr), up to 28% atomic ratio of molybdenum (Mo), up to 4% atomic ratio of tungsten (W), up to 2% atomic ratio of carbon (C), up to 3% atomic ratio of copper (Cu), up to 11% atomic ratio of silicon (Si), up to 10% atomic ratio of niobium (Nb), up to 10% atomic ratio of tantalum (Ta), up to 2% atomic ratio of aluminum (Al), and up to 2% atomic ratio of titanium (Ti).

10. The magnetic recording medium of claim 1, wherein the magnetically soft alloy has a high saturation magnetic induction (Bs) greater than 0.5 Tesla.

11. The magnetic recording medium of claim 10, wherein the magnetically soft alloy also has a high permeability (µₑ) of greater than 10.0 at 1KHz, and a low coercivity (Hc) of less than 8000 oestead.

12. A magnetic recording head, comprising:
a writer pole; and
a reader sensor,
wherein the writer pole and the reader sensor include a magnetically soft film deposited above a substrate, the magnetically soft film being comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al).

13. The magnetic recording head of claim 12, wherein the at least one soft ferromagnetic element is selected from the group consisting of cobalt (Co), iron (Fe) and nickel (Ni).

14. The magnetic recording head of claim 12, wherein the at least one soft ferromagnetic element is a combination of at least two elements selected from the group consisting of cobalt (Co), iron (Fe) and nickel (Ni).

15. The magnetic recording head of claim 12, wherein the at least one soft ferromagnetic element is cobalt (Co), and the at least one corrosion inhibitor element is selected from the group consisting of chromium (Cr), tungsten (W), molybdenum (Mo), carbon (C), copper (Cu), and nickel (Ni).

16. The magnetic recording head of claim 15, wherein the selected corrosion inhibitor element is included in the magnetically soft alloy according to the following atomic ratio limits: up to 25% atomic ratio of chromium (Cr), up to 15% atomic ratio of tungsten (W), up to 10% atomic ratio of molybdenum (Mo), up to 2% atomic ratio of carbon (C), up to 2% atomic ratio of copper (Cu), and up to 20% atomic ratio of nickel (Ni).

17. The magnetic recording head of claim 12, wherein the at least one soft ferromagnetic element is iron (Fe), and the at least one corrosion inhibitor element is selected from the group consisting of chromium (Cr), tungsten (W), molybdenum (Mo), carbon (C), nickel (Ni), manganese (Mn), nitrogen (N), titanium (Ti), niobium (Nb), and silicon (Si).

18. The magnetic recording head of claim 17, wherein the selected corrosion inhibitor element is included in the magnetically soft alloy according to the following atomic ratio limits: up to 30% atomic ratio of chromium (Cr), up to 5% atomic ratio of tungsten (W), up to 5% atomic ratio of molybdenum (Mo), up to 0.3% atomic ratio of carbon (C), up to 30% atomic ratio of nickel (Ni), up to 15% atomic ratio of manganese (Mn), up to 0.4% atomic ratio of nitrogen (N), up to 2% atomic ratio of titanium (Ti), up to 2% atomic ratio of niobium (Nb), and up to 1% atomic ratio of silicon (Si).

19. The magnetic recording head of claim 12, wherein the at least one soft ferromagnetic element is nickel (Ni), and the at least one corrosion inhibitor element is selected from the group consisting of chromium (Cr), tungsten (W), molybdenum (Mo), carbon (C), copper (Cu), titanium (Ti), niobium (Nb), silicon (Si), tantalum (Ta), and aluminum (Al).

20. The magnetic recording head of claim 19, wherein the selected corrosion inhibitor element is included in the magnetically soft alloy according to the following atomic ratio limits: up to 30% atomic ratio of chromium (Cr), up to 28% atomic ratio of molybdenum (Mo), up to 4% atomic ratio of tungsten (W), up to 2% atomic ratio of carbon (C), up to 3% atomic ratio of copper (Cu), up to 11 % atomic ratio of silicon (Si), up to 10% atomic ratio of niobium (Nb), up to 10% atomic ratio of tantalum (Ta), up to 2% atomic ratio of aluminum (Al), and up to 2% atomic ratio of titanium (Ti).

21. The magnetic recording head of claim 12, wherein the magnetically soft alloy has a high saturation magnetic induction (Bs) greater than 0.5 Tesla.

22. The magnetic recording head of claim 21, wherein the magnetically soft alloy also has a high permeability (µₑ) of greater than 10.0 at 1KHz, and a low coercivity (Hc) of less than 8000 oestead.

23. A method of manufacturing a magnetic recording medium, comprising:
a first sputtering step of sputtering an underlayer above a substrate from a first sputter target that is comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (A1); and
a second sputtering step of sputtering a magnetic data recording layer above the underlayer from a second sputter target.

24. The method of claim 23, wherein the at least one soft ferromagnetic element is selected from the group consisting of cobalt (Co), iron (Fe) and nickel (Ni).

25. The method of claim 23, wherein the at least one soft ferromagnetic element is cobalt (Co), and the at least one corrosion inhibitor element is selected from the group consisting of chromium (Cr), tungsten (W), molybdenum (Mo), carbon (C), copper (Cu), and nickel (Ni).

26. The method of claim 25, wherein the selected corrosion inhibitor element is included in the magnetically soft alloy according to the following atomic ratio limits: up to 25% atomic ratio of chromium (Cr), up to 15% atomic ratio of tungsten (W), up to 10% atomic ratio of molybdenum (Mo), up to 2% atomic ratio of carbon (C), up to 2% atomic ratio of copper (Cu), and up to 20% atomic ratio of nickel (Ni).

27. The method of claim 23, wherein the at least one soft ferromagnetic element is iron (Fe), and the at least one corrosion inhibitor element is selected from the group consisting of chromium (Cr), tungsten (W), molybdenum (Mo), carbon (C), nickel (Ni), manganese (Mn), nitrogen (N), titanium (Ti), niobium (Nb), and silicon (Si).

28. The method of claim 27, wherein the selected corrosion inhibitor element is included in the magnetically soft alloy according to the following atomic ratio limits: up to 30% atomic ratio of chromium (Cr), up to 5% atomic ratio of tungsten (W), up to 5% atomic ratio of molybdenum (Mo), up to 0.3% atomic ratio of carbon (C), up to 30% atomic ratio of nickel (Ni), up to 15% atomic ratio of manganese (Mn), up to 0.4% atomic ratio of nitrogen (N), up to 2% atomic ratio of titanium (Ti), up to 2% atomic ratio of niobium (Nb), and up to 1% atomic ratio of silicon (Si).

29. The method of claim 23, wherein the at least one soft ferromagnetic element is nickel (Ni), and the at least one corrosion inhibitor element is selected from the group consisting of chromium (Cr), tungsten (W), molybdenum (Mo), carbon (C), copper (Cu), titanium (Ti), niobium (Nb), silicon (Si), tantalum (Ta), and aluminum (A1).

30. The method of claim 29, wherein the selected corrosion inhibitor element is included in the magnetically soft alloy according to the following atomic ratio limits: up to 30% atomic ratio of chromium (Cr), up to 28% atomic ratio of molybdenum (Mo), up to 4% atomic ratio of tungsten (W), up to 2% atomic ratio of carbon (C), up to 3% atomic ratio of copper (Cu), up to 11 % atomic ratio of silicon (Si), up to 10% atomic ratio of niobium (Nb), up to 10% atomic ratio of tantalum (Ta), up to 2% atomic ratio of aluminum (Al), and up to 2% atomic ratio of titanium (Ti).

31. A sputter target comprising:
a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al).

32. The sputter target of claim 31, wherein the at least one soft ferromagnetic element is selected from the group consisting of cobalt (Co), iron (Fe) and nickel (Ni).

33. The sputter target of claim 31, wherein the at least one soft ferromagnetic element is cobalt (Co), and the at least one corrosion inhibitor element is selected from the group consisting of chromium (Cr), tungsten (W), molybdenum (Mo), carbon (C), copper (Cu), and nickel (Ni).

34. The sputter target of claim 33, wherein the selected corrosion inhibitor element is included in the magnetically soft alloy according to the following atomic ratio limits: up to 25% atomic ratio of chromium (Cr), up to 15% atomic ratio of tungsten (W), up to 10% atomic ratio of molybdenum (Mo), up to 2% atomic ratio of carbon (C), up to 2% atomic ratio of copper (Cu), and up to 20% atomic ratio of nickel (Ni).

35. The sputter target of claim 31, wherein the at least one soft ferromagnetic element is iron (Fe), and the at least one corrosion inhibitor element is selected from the group consisting of chromium (Cr), tungsten (W), molybdenum (Mo), carbon (C), nickel (Ni), manganese (Mn), nitrogen (N), titanium (Ti), niobium (Nb), and silicon (Si).

36. The sputter target of claim 35, wherein the selected corrosion inhibitor element is included in the magnetically soft alloy according to the following atomic ratio limits: up to 30% atomic ratio of chromium (Cr), up to 5% atomic ratio of tungsten (W), up to 5% atomic ratio of molybdenum (Mo), up to 0.3% atomic ratio of carbon (C), up to 30% atomic ratio of nickel (Ni), up to 15% atomic ratio of manganese (Mn), up to 0.4% atomic ratio of nitrogen (N), up to 2% atomic ratio of titanium (Ti), up to 2% atomic ratio of niobium (Nb), and up to 1 % atomic ratio of silicon (Si).

37. The sputter target of claim 31, wherein the at least one soft ferromagnetic element is nickel (Ni), and the at least one corrosion inhibitor element is selected from the group consisting of chromium (Cr), tungsten (W), molybdenum (Mo), carbon (C), copper (Cu), titanium (Ti), niobium (Nb), silicon (Si), tantalum (Ta), and aluminum (A1).

38. The sputter target of claim 37, wherein the selected corrosion inhibitor element is included in the magnetically soft alloy according to the following atomic ratio limits: up to 30% atomic ratio of chromium (Cr), up to 28% atomic ratio of molybdenum (Mo), up to 4% atomic ratio of tungsten (W), up to 2% atomic ratio of carbon (C), up to 3% atomic ratio of copper (Cu), up to 11 % atomic ratio of silicon (Si), up to 10% atomic ratio of niobium (Nb), up to 10% atomic ratio of tantalum (Ta), up to 2% atomic ratio of aluminum (Al), and up to 2% atomic ratio of titanium (Ti).

39. The sputter target of claim 31, wherein the magnetically soft alloy has a high saturation magnetic induction (Bs) greater than 0.5 Tesla.

40. The sputter target of claim 39, wherein the magnetically soft alloy also has a high permeability (µₑ) of greater than 10.0 at 1KHz, and a low coercivity (Hc) of less than 8000 oestead.

41. A method of manufacturing a magnetic recording head having a writer pole and a reader sensor, comprising:
a sputtering step of sputtering a magnetically soft film above a substrate deposited on at least one of the writer pole and the reader sensor, the magnetically soft film being sputtered from a sputter target that is comprised of a magnetically soft alloy containing at least one soft ferromagnetic element and at least one corrosion inhibitor element that is selected from the group consisting of chromium (Cr), tungsten (W), molybdenum (Mo), carbon (C), copper (Cu), nickel (Ni), manganese (Mn), nitrogen (N), titanium (Ti), niobium (Nb), silicon (Si), tantalum (Ta), and aluminum (Al).

42. The method of claim 41, wherein the at least one soft ferromagnetic element is selected from the group consisting of cobalt (Co), iron (Fe) and nickel (Ni).

43. The method of claim 41, wherein the at least one soft ferromagnetic element is cobalt (Co), and the at least one corrosion inhibitor element is selected from the group consisting of chromium (Cr), tungsten (W), molybdenum (Mo), carbon (C), copper (Cu), and nickel (Ni).

44. The method of claim 43, wherein the selected corrosion inhibitor element is included in the magnetically soft alloy according to the following atomic ratio limits: up to 25% atomic ratio of chromium (Cr), up to 15% atomic ratio of tungsten (W), up to 10% atomic ratio of molybdenum (Mo), up to 2% atomic ratio of carbon (C), up to 2% atomic ratio of copper (Cu), and up to 20% atomic ratio of nickel (Ni).

45. The method of claim 41, wherein the at least one soft ferromagnetic element is iron (Fe), and the at least one corrosion inhibitor element is selected from the group consisting of chromium (Cr), tungsten (W), molybdenum (Mo), carbon (C), nickel (Ni), manganese (Mn), nitrogen (N), titanium (Ti), niobium (Nb), and silicon (Si).

46. The method of claim 45, wherein the selected corrosion inhibitor element is included in the magnetically soft alloy according to the following atomic ratio limits: up to 30% atomic ratio of chromium (Cr), up to 5% atomic ratio of tungsten (W), up to 5% atomic ratio of molybdenum (Mo), up to 0.3% atomic ratio of carbon (C), up to 30% atomic ratio of nickel (Ni), up to 15% atomic ratio of manganese (Mn), up to 0.4% atomic ratio of nitrogen (N), up to 2% atomic ratio of titanium (Ti), up to 2% atomic ratio of niobium (Nb), and up to 1% atomic ratio of silicon (Si).

47. The method of claim 41, wherein the at least one soft ferromagnetic element is nickel (Ni), and the at least one corrosion inhibitor element is selected from the group consisting of chromium (Cr), tungsten (W), molybdenum (Mo), carbon (C), copper (Cu), titanium (Ti), niobium (Nb), silicon (Si), tantalum (Ta), and aluminum (Al).

48. The method of claim 47, wherein the selected corrosion inhibitor element is included in the magnetically soft alloy according to the following atomic ratio limits: up to 30% atomic ratio of chromium (Cr), up to 28% atomic ratio of molybdenum (Mo), up to 4% atomic ratio of tungsten (W), up to 2% atomic ratio of carbon (C), up to 3% atomic ratio of copper (Cu), up to 11% atomic ratio of silicon (Si), up to 10% atomic ratio of niobium (Nb), up to 10% atomic ratio of tantalum (Ta), up to 2% atomic ratio of aluminum (Al), and up to 2% atomic ratio of titanium (Ti).
